# EUROPÄISCHE PATENTSCHRIFT

(11) **EP 1 527 483 B1**
(45) Veröffentlichungstag und Bekanntmachung des Hinweises auf die Patenterteilung: **10.10.2007**
(21) Anmeldenummer: 03765056.1
(22) Anmeldetag: 18.07.2003
(51) Int. Cl.: H01L 41/047

(54) **AUSSENELEKTRODE AN EINEM PIEZOKERAMISCHEN VIELSCHICHTAKTOR**
EXTERNAL ELECTRODE ON A PIEZOCERAMIC MULTI-LAYER ACTUATOR
ELECTRODE EXTERNE DISPOSEE SUR UN ACTIONNEUR PIEZOCERAMIQUE MULTICOUCHE

(30) Priorität: 19.07.2002 DE 10233057; 20.06.2003 DE 10327902
(43) Veröffentlichungstag der Anmeldung: 04.05.2005
(73) Patentinhaber: CeramTec AG Innovative Ceramic Engineering, 73207 Plochingen (DE)
(72) Erfinder: BINDIG, Reiner, 95463 Bindlach (DE); SCHREINER, Hans-Jürgen, 91233 Neunkirchen am Sand-Rollhofen (DE); SCHMIEDER, Jürgen, 91207 Lauf (DE)
(74) Vertreter: Uppena, Franz
(86) Internationale Anmeldenummer: PCT/EP2003/007893
(87) Internationale Veröffentlichungsnummer: WO 2004/010511

(56) Entgegenhaltungen:
- EP-A- 0 844 678
- EP-A- 1 065 735
- WO-A-00/63980

## Beschreibung

Die Erfindung betrifft eine Außenelektrode an einem piezokeramischen Vielschichtaktor.

Piezokeramische Vielschichtaktoren werden als Monolithen hergestellt, das heißt, der aktive Werkstoff, auf dem vor dem Sintern durch ein Siebdruckverfahren Innenelektroden aufgetragen werden, wird als sogenannte Grünfolie zu einem Stapel aufeinandergelegt, der zu einem Grünkörper verpresst wird. Das Verpressen des Grünkörpers wird in der Regel durch Laminieren unter Druck- und Temperatureinwirkung in Laminierformen durchgeführt.

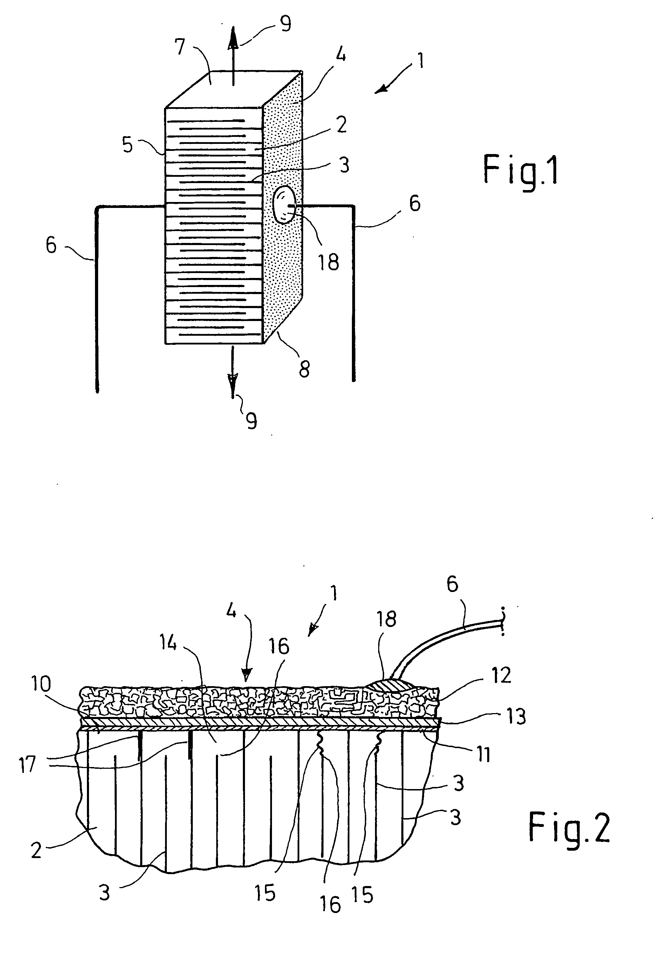

In Figur 1 ist ein solcherart hergestellter piezokeramischer Vielschichtaktor 1 stark vergrößert schematisch dargestellt. Der Aktor besteht aus gestapelten dünnen Schichten 2 piezoelektrisch aktiven Werkstoffs, beispielsweise Blei-Zirkonat-Titanat (PZT), mit dazwischen angeordneten leitfähigen Innenelektroden 3, die alternierend an die Aktoroberfläche geführt werden. Außenelektroden 4, 5 verbinden die Innenelektroden 3. Dadurch werden die Innenelektroden 3 elektrisch parallel geschaltet und zu zwei Gruppen zusammengefasst. Die beiden Außenelektroden 4, 5 sind die Anschlusspole des Aktors 1. Sie sind über die Anschlüsse 6 mit einer hier nicht dargestellten Spannungsquelle verbunden. Wird über die Anschlüsse 6 eine elektrische Spannung an die Außenelektroden 4, 5 gelegt, wird diese auf alle Innenelektroden 3 parallel übertragen und verursacht ein elektrisches Feld in allen Schichten 2 des aktiven Werkstoffs, der sich dadurch mechanisch verformt. Die Summe aller dieser mechanischen Verformungen steht an der Endfläche des Kopfbereichs 7 sowie an der Endfläche des Fußbereichs 8 des Vielschichtaktors 1 als nutzbare Dehnung und/oder Kraft 9 zur Verfügung.

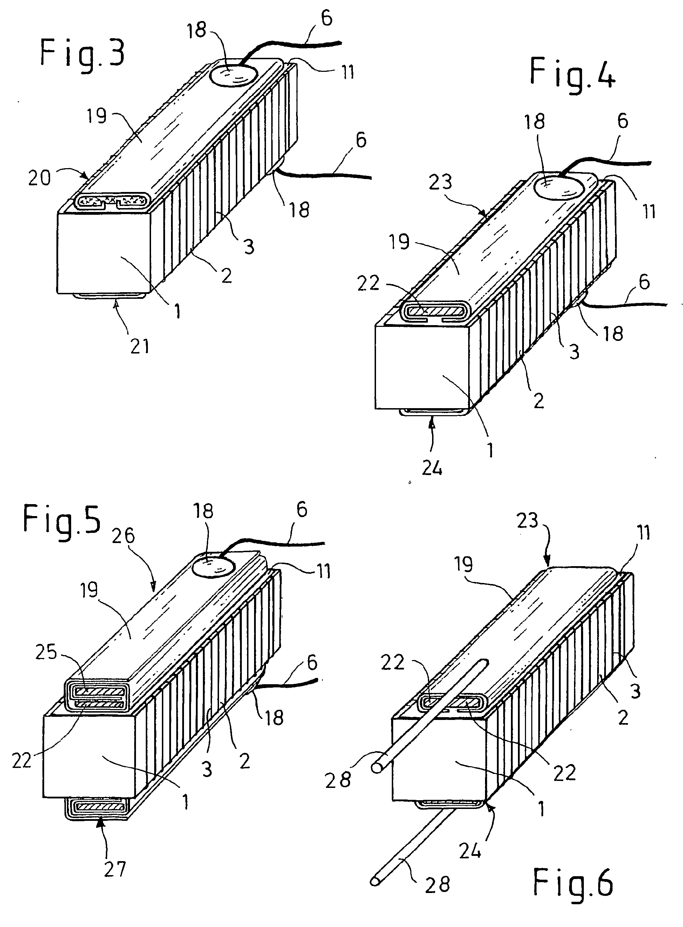

Die Figur 2 zeigt einen Schnitt durch eine Außenelektrode 4 und die Oberfläche eines piezokeramischen Vielschichtaktors 1 nach dem Stand der Technik. Auf die zu einem Stapel gepressten dünnen Schichten 2 des piezoelektrisch aktiven Werkstoffs wird im Bereich der an die Oberfläche 10 des Vielschichtaktors 1 herausgeführten Innenelektroden 3, beispielsweise durch galvanische Verfahren oder Siebdruck von Metallpaste, eine Grundmetallisierung 11 zur Verbindung der gleichgepolten Innenelektroden 3 aufgebracht. Diese Grundmetallisierung 11 wird durch eine weitere Schicht aus einem metallischen Werkstoff verstärkt, beispielsweise durch ein strukturiertes Blech oder ein Drahtnetz als dreidimensional strukturierte Elektrode 12, wie sie aus der EP 0 844 678 A1 bekannt ist. Die Verbindung der dreidimensional strukturierten Elektrode 12 mit der Grundmetallisierung 11 erfolgt mittels einer Verbindungsschicht 13, in der Regel einer Lotschicht. An die dreidimensional strukturierte Elektrode 12 wird an der Kontaktstelle 18 mittels einer Lötperle der elektrische Anschlussdraht 6 gelötet.

Bei Außenelektroden auf der Oberfläche 10 eines Aktors 1, die wie beschrieben aufgebaut sind, wirken während des Betriebes auf den inaktiven Bereich, den Isolierbereich 14, der unter der Grundmetallisierung 11 liegt, starke Zugspannungen. Da dieser Isolierbereich 14 zusammen mit der Grundmetallisierung 11 und der Verbindungsschicht 13 eine homogene Einheit bildet, versagt diese beim Überschreiten der Zugfestigkeit des schwächsten Gliedes und es bilden sich Risse. Der dargestellte Rissverlauf tritt nach etwa 10⁶ Belastungszyklen auf. Aufgrund der auftretenden Spannungen verlaufen die Risse 15 in der Regel von der spröden und wenig zugfesten Grundmetallisierung 11 in den Isolierbereich 14 und werden dort von Bereichen mit hohen Zugspannungen eingefangen, bevorzugt an den Elektrodenspitzen 16 der nicht die Grundmetallisierung 11 berührenden Elektroden 3, oder sie beginnen in den Bereichen maximaler Zugspannung an den Elektrodenspitzen 16 und verlaufen in Richtung der Grundmetallisierung 11. Die Ausbreitung eines Risses 17 entlang einer die Grundmetallisierung 11 berührenden Innenelektrode 3 ist als unkritisch einzustufen, da ein solcher Rissverlauf die Funktion des Aktors nicht beeinträchtigt. Wird die Grundmetallisierung 11 durch einen Riss durchtrennt, wirkt die elastische, dreidimensional strukturierte Elektrode 12 als elektrische Brücke, so dass der Riss ohne Einfluss auf die Eigenschaften oder die Lebensdauer des Aktors 1 bleibt. Risse 15 dagegen, die unkontrolliert durch den Isolierbereich 14 verlaufen, sind sehr kritisch, da sie den Isolationsabstand verringern und die Wahrscheinlichkeit eines Aktorausfalls durch Überschläge stark erhöhen.

Zu Problemen führen die solcher Art aufgebauten Elektroden allerdings beim Anschließen einer leitenden Verbindung, über welche die elektrische Spannung zugeführt werden soll.

Nach dem Stand der Technik wird im Kontaktpunkt 18 ein Draht 6 an die dreidimensional strukturierte Elektrode 12 gelötet oder geschweißt, wie es in Fig. 2 dargestellt ist. Durch das Löten oder die Schweißung wird die dreidimensional strukturierte Elektrode 12 jedoch versteift und verliert somit am Löt- oder Schweißpunkt 18 die Elastizität. Im Betrieb treten dann unterhalb dieser Löt- oder Schweißpunkte 18 mechanische Scherspannungen auf, da sich der darüber liegende Elektrodenbereich nicht mehr mit ausdehnt. Dies kann nach einigen Millionen Betriebszyklen zum Ablösen der Metallelektrode samt Grundmetallisierung und dadurch zum Ausfall des Bauteils führen.

Aus der DE 100 26 005 A1 ist es bekannt, dass die dreidimensional strukturierte Elektrode über den Aktor übersteht und dort, gegebenenfalls an die umgefaltete oder gerollte Elektrode, der elektrische Kontakt angelötet wird. Die überstehenden Enden sind durch einen Schrumpfschlauch isoliert. Diese Art des Anschlusses ist aufwändig und führt zu einer kompliziert aufgebauten Außenelektrode. An den Knickstellen der Elektrode können Kerbwirkungen auftreten.

Aus der DE 199 09 452 C1 ist es bekannt, an einer Seite des Aktors, beispielsweise am Fuß, einen piezoelektrisch nicht aktiven Bereich vorzusehen und in diesem Bereich den elektrischen Kontakt anzubringen. Der passive Fuß bewirkt eine deutlich verringerte Steifigkeit und Ausdehnung bei gleicher Baulänge des Bauteils, weil der passive Fuß wie eine steife Feder wirkt und den aktiven Bereich verkürzt.

Aufgabe der vorliegenden Erfindung ist es, durch Gestaltung der Elektroden den Anschluss der Spannungszuführung an die Außenelektroden zu verbessern.

Die Lösung der Aufgabe erfolgt dadurch, dass die Außenelektrode aus abwechselnd übereinander angeordneten Schichten leitender und nicht leitender Werkstoffe besteht, dass von den beiden außen liegenden Schichten aus leitenden Werkstoffen die eine mit der Grundmetallisierung des Aktors verbunden ist und die andere mit der Zuleitung für die Spannung und dass die Schichten aus den leitenden Werkstoffen leitend miteinander verbunden sind.

Durch die abwechselnd übereinander angeordneten Schichten leitender und nicht leitender Werkstoffe werden die Schichten der leitenden Werkstoffe mechanisch voneinander entkoppelt. Die elektrische Verbindung miteinander wird gesondert hergestellt oder über eine Faltung einer durchgehenden Folie als leitender Werkstoff erhalten. Die untere, mit der Grundmetallisierung durch Löten oder Kleben verbundene leitende Schicht kann sich deshalb innerhalb bestimmter Grenzen unabhängig von den oberen Schichten bewegen und dadurch auftretende Spannungen ausgleichen.

Eine angelötete oder angeschweißte elektrische Kontaktierung ist nur mit der obersten leitenden Schicht verbunden. Dadurch wird ein Durchlöten der Schicht verhindert. Die Kontaktierung des Anschlussdrahtes an die äußere leitende Schicht der Außenelektrode wirkt sich nicht mehr versteifend auf die Elektrode aus. Die über die Grundmetallisierung auf die Außenelektrode wirkenden Kräfte werden aufgrund des Schichtaufbaus in vorteilhafter Weise so gedämpft, dass sie keine Auswirkungen auf die Anschlussstelle haben.

An Aktoren mit erfindungsgemäßen Außenelektroden können elektrische Kontaktierungen an jeder Stelle der Außenelektrode angebracht werden, ohne dass dies einen Einfluss auf die Lebensdauer oder sonstige Eigenschaften des Aktors hat. Dadurch ist es möglich kompakte Aktormodule ohne aufwendige oder störende Schutzmaßnahmen herzustellen, wie sie aus dem Stand der Technik bekannt sind.

Eine erfindungsgemäß aufgebaute Außenelektrode besteht aus mindestens zwei Lagen eines leitenden Werkstoffs und einer dazwischen angeordneten Lage eines nicht leitenden Werkstoffs.

Der leitende Werkstoff kann aus Metallfolien bestehen, die sich aufgrund ihrer geringen Dicke leicht verarbeiten lassen. Die Dicke der Folien liegt etwa zwischen 30 µm und 200 µm, vorzugsweise zwischen 50 µm und 100 µm. Die Folien können auch in sich strukturiert sein, beispielsweise durch eine Prägung. Dadurch kann ihre Gesamtdicke bis auf das dreifache der Foliendicke anwachsen.

Die Schichten der leitenden Werkstoffe können auch in sich dreidimensional strukturiert sein. Es sind dann keine massive Schichten, sondern sie bestehen aus einem Metallgewebe oder -gewirk, aus einem Netz oder aus Metallschaum.

Die Gewebe, Gewirke oder Netze aus Metalldrähten haben eine Dicke von etwa 100 µm bis zu 200 µm. Die Maschenweite der Gewirke oder Netze liegt zwischen etwa 100 µm und 200 µm bei Drahtdurchmessern zwischen etwa 50 µm und 100 µm.

Die Schichten aus nicht leitendem Werkstoff bestehen aus einem elastischen Kunststoff, vorzugsweise einem thermoplastischen Kunststoff wie Polytetrafluorethylen (Teflon) oder Polyimid. Die Schichten sind Folien mit einer Dicke von etwa 10 µm bis zu etwa 100 µm.

Der leitende Werkstoff einer Schicht kann auch mit dem nicht leitenden Werkstoff einer Schicht beschichtet sein. Das können beispielsweise einseitig mit Kunststoff beschichtete Folien sein. Diese lassen sich beispielsweise durch Falten zu einer erfindungsgemäßen Außenelektrode gestalten. Weiterhin können auch sich abwechselnde Lagen leitender und nicht leitender Werkstoffe zusammenlaminiert sein.

Die einzelnen Schichten der leitenden Werkstoffe können aus unterschiedlichen metallischen Werkstoffen bestehen. So ist es beispielsweise möglich, den metallischen Werkstoff mindestens der Schicht, die auf den Aktorwerkstoff gelötet oder geklebt ist, so zu wählen, dass er einen dem keramischen Werkstoff des Aktors angepassten Wärmeausdehnungskoeffizienten besitzt.

Um die leitenden Verbindungen zwischen den Schichten aus den metallischen Werkstoffen herzustellen, sind diese Schichten durchkontaktiert oder umkontaktiert. Dazu sind die Schichten beiderseits ihrer Längsseiten leitend miteinander verbunden, beispielsweise durch Verlöten der überstehenden Seiten.

Weiterhin ist es möglich, einen leitenden Werkstoff, vorzugsweise in Form einer Folie oder eines Gewebes, mäanderförmig oder spiralförmig zu falten, so dass der nicht leitende Werkstoff jeweils als Schicht zwischen den Falten beziehungsweise innerhalb einer Wicklung liegt. Dadurch wird folgender Effekt erzielt: Durch die Unterbrechung der Lagen der Folie oder des Gewebes mit Kunststofflagen wird sichergestellt, dass eine angelötete oder angeschweißte elektrische Kontaktierung nur mit der oberen leitenden Schicht verbunden ist. Dadurch wird ein Durchlöten und Versteifen der Schichten verhindert.

Im Folgenden wird die Herstellung eines erfindungsgemäßen Aktors beschrieben. Eine niedrig sinternde Piezokeramik nach DE 198 40 488 wird mit einem organischen Bindersystem als 125 µm dicke Folie präpariert. Auf diese Folie wird Innenelektrodenpaste aus Silber-Palladium Pulver in Gewichtsverhältnis 70/30 und einem geeigneten Bindersystem mittels Siebdruck aufgebracht. Eine Vielzahl derartiger Folien wird gestapelt und zu einem Laminat verpresst. Das Laminat wird zu einzelnen, stabförmigen Aktoren zertrennt, diese werden bei ca. 400°C pyrolysiert und bei etwa 1100 °C gesintert. Anschließend werden die Aktorgrundkörper an allen Seiten mechanisch bearbeitet.

Die Grundmetallisierung, beispielsweise aus einer geeigneten Silber-Palladium Terminierungspaste, wird mittels eines Siebdruck/Einbrennprozesses aufgebracht

Eine erfindungsgemäße, strukturierte, gefaltete Außenelektrode wird auf diese Grundmetallisierung aufgelötet.

Die elektrische Verbindung kann anschließend z. B. durch Löten oder Schweißen angebracht werden. Dieser Arbeitsgang kann auch vorgezogen werden, z.B. indem man an die gefaltete Elektrode vor dem Auflöten auf den Aktor einen Kontaktstift anbringt. Die Aktoren werden anschließend durch eine Lackschicht geschützt. Es ist auch möglich, die Kontaktierung erst nach dem Lackieren anzubringen, wobei dann der Löt- oder Schweißbereich in der Regel lackfrei gehalten werden muss. Die Aktoren werden abschließend polarisiert und elektrisch gemessen.

Anhand von Ausführungsbeispielen wird die Erfindung näher erläutert. Es zeigen:
Figur 1 schematisch den Aufbau eines monolithischen Vielschichtaktors nach dem Stand der Technik,
Figur 2 einen Ausschnitt aus dem Aktor nach Figur 1 mit den typischen Rissen, die sich nach etwa 10⁶ Belastungszyklen einstellen,
Figur 3 einen Aktor mit einer gefalteten Metallnetzelektrode nach dem Stand der Technik,
Figur 4 einen Aktor mit einer erfindungsgemäßen einfach gefalteten Metallnetzelektrode und einer Kunststoffeinlage,
Figur 5 einen Aktor mit einer erfindungsgemäßen spiralförmig gefalteten Metallnetzelektrode und zwei Kunststoffeinlagen und
Figur 6 einen Aktor mit einer erfindungsgemäßen einfach gefalteten Metallnetzelektrode und einer Kunststoffeinlage und angeschweißten Anschlussstiften.

Anhand von vier Ausführungsbeispielen wird das Herstellen der erfindungsgemäßen Außenelektroden beschrieben.

Wie oben ausgeführt werden Aktorgrundkörper 1 der Abmessung 10 mm x 10 mm (Grundfläche) und 30 mm Länge präpariert. Die Dicke einer Keramikeinzellage 2 beträgt nach dem Sintern 100 µm, die Dicke einer Innenmetallisierungsschicht 2 µm. Die Grundmetallisierung 3 wird mit einer handelsüblichen Terminierungspaste per Siebdruck erzeugt, und bei 750 °C an Luft 30 Minuten lang eingebrannt. Die Schichtdicke nach dem Einbrennen beträgt 10 µm bis 12 µm. Diese Aktorgrundkörper werden wie folgt weiterbehandelt:

Beispiel 1: Nach Fig. 3 wird als leitender Werkstoff ein Drahtgewebe 19 aus Kupferbronzedrähten (CuSn₆) mit Drahtdurchmessern von 0,1 mm und einer Maschenweite von 0,2 mm galvanisch 20 µm dick mit Lot (SnPb₁₀) beschichtet. Aus dem Gewebe wird in einem Winkel von 45° zur Richtung der Kettfäden ein 8 mm breiter und 29 mm langer Streifen herausgeschnitten. Dieser Streifen wird längs so gefaltet, dass die beiden Ränder mittig zu liegen kommen.

Außenelektroden 20, 21 dieser Art werden an den gegenüberliegenden Anschlussflächen auf die Grundmetallisierung 11 des Aktorgrundkörpers, z. B. mit einem Reflowlötverfahren, aufgelötet. Auf die sich gegenüberliegenden Außenelektroden 20, 21 wird in der Nähe einer Aktorstirnfläche jeweils ein Lötpunkt 18 für die Anschlussdrähte 6 aufgebracht. Diese Vorgehensweise stellt den Stand der Technik dar. Die Lötzeit beträgt 10 Minuten bei 240 °C.

Beispiel 2: Nach Fig. 4 wird ein Drahtgewebe 19 aus Kupferbronzedrähten (CuSn₆) mit Drahtdurchmessern von 0,1 mm und einer Maschenweite von 0,2 mm galvanisch 20 µm dick mit Lot (SnPb₁₀) beschichtet. Aus dem Gewebe wird in einem Winkel von 45° zur Richtung der Kettfäden ein 8 mm breiter und 29 mm langer Streifen herausgeschnitten. Auf diesen Streifen wird mittig ein Streifen 22 mit den Abmessungen 3,5 mm x 29 mm aus PTFE-Polymer gelegt. Um diesen wird der Gewebestreifen 19 längs so gefaltet, dass die beiden Ränder mittig zu liegen kommen.

Außenelektroden dieser Art werden auf die Grundmetallisierung des Aktorgrundkörpers, z. B. mit einem Reflowlötverfahren, aufgelötet. Auf die sich gegenüberliegenden Außenelektroden 23, 24 wird in der Nähe einer Aktorstirnfläche jeweils ein Lötpunkt 18 für die Anschlussdrähte 6 aufgebracht. Die Lötzeit beträgt 10 Minuten bei 240 °C.

Beispiel 3: Nach Fig. 5 wird ein Drahtgewebe 19 aus Kupferbronzedrähten (CuSn₆) mit Drahtdurchmessern von 0,1 mm und einer Maschenweite von 0,2 mm galvanisch 20 µm dick mit Lot (SnPb₁₀) beschichtet. Aus dem Gewebe wird in einem Winkel von 45° zur Richtung der Kettfäden ein 16 mm breiter und 29 mm langer Streifen herausgeschnitten. Auf diesen Streifen wird außermittig ein Streifen mit den Abmessungen 3,5 mm x 29 mm aus PTFE-Polymer gelegt 22. Um diesen wird der Gewebestreifen 19 längs gefaltet. Abermals wird ein PTFE-Streifen 25 aufgelegt und der Gewebestreifen spiralförmig herumgefaltet.

Außenelektroden dieser Art werden auf die Grundmetallisierung 11 des Aktorgrundkörpers, z.B. mit einem Reflowlötverfahren, aufgelötet, so dass die doppelt liegende Metallnetz-Schicht vom Aktor wegweist. Auf die sich gegenüberliegenden Außenelektroden 26, 27 wird in der Nähe einer Aktorstirnfläche jeweils ein Lötpunkt 18 für die Anschlussdrähte 6 aufgebracht. Die Lötzeit beträgt 10 Minuten bei 240 °C.

Beispiel 4: Nach Fig. 6, das Ausführungsbeispiel 2 nach Fig. 4 entspricht, wird ein Drahtgewebe 19 aus einer Eisen-Nickel-Legierung (FeNi₄₂) mit Drahtdurchmessern von 0,08 mm und einer Maschenweite von 0,18 mm galvanisch 6 µm dick mit Kupfer und 20 µm dick mit Lot (SnPb₁₀) beschichtet. Aus dem Gewebe wird in einem Winkel von 45° zur Richtung der Kettfäden ein 8 mm und 29 mm langer breiter Streifen herausgeschnitten. Auf diesen Streifen wird mittig ein Streifen mit den Abmessungen 3,5 mm x 29 mm aus Polyimid-Polymer 22 gelegt. Um diesen wird der Gewebestreifen längs so gefaltet, dass die beiden Ränder mittig zu liegen kommen. Auf die so hergestellte Außenelektrode 23, 24 wird ein Metallstift 28 mit 0,8 mm Durchmesser etwa. 5 mm überlappend mittels Widerstandsschweißen aufgeschweißt, so dass der Stift 28 einseitig über das Drahtnetz 19 übersteht.

Bei dieser Ausführung ist der angepasste Temperaturausdehnungskoeffizient des Netzmaterials und der bereits vorgeformte Anschlussstift von Vorteil.

Außenelektroden dieser beschriebenen Art werden auf die Grundmetallisierung des Aktorgrundkörpers, z. B. mit einem Reflowlötverfahren, aufgelötet. Die Lötzeit beträgt 10 Minuten bei 240 °C.

Die vier Varianten werden mit einem geeigneten Verfahren mit Silikonlack überzogen, z.B. durch Tauchen oder Sprühen.

Nach dem Trocknen und Aushärten des Lackes wird von den Lötpunkten der Varianten 1 bis 3 der Lack wieder entfernt und ein Anschlussdraht angelötet.

Die Aktoren werden in Prüfrahmen mit 2000 N vorgespannt und mit einem Trapezsignal angesteuert. Dabei wird die Ansteuerspannung in 100 µs von 0 V auf 200 V angehoben, 1 ms auf 200 V gehalten, und dann in 100 µs auf 0 V abgesenkt. Die Wiederholfrequenz ist 200 Hz. Die Aktoren erreichen dabei Betriebstemperaturen von 150 °C bis 160 °C.

Das Beispiel1 zeigt bereits bei 10⁷ Zyklen deutliche Ablösung der Netzelektrode von der Keramik im Bereich der Lötpunkte. Nach 2.10⁷ Zyklen ist der Aktor durch Lichtbogenbildung an der Lötpunkten zerstört.

Die Beispiele 2 bis 4 zeigen identisches Verhalten, das sich von Beispiel 1 deutlich unterscheidet. Selbst bei 10⁹ Zyklen tritt bei keinem der Beispiele Netzablösung oder Lichtbogenbildung auf.

Bei der Herstellung der erfindungsgemäßen . Außenelektroden kann der Fachmann verschiedene Wege auswählen. So können die Außenelektroden zum Beispiel aus dünnem, mit Kunststoff beschichteten Blech oder, wie beschrieben, als Metallnetz um einen Kunststoffstreifen gefaltet sein. Auch die Herstellung analog einer Leiterplatte ist möglich, indem Kunststoff- und Metallschichten aufeinanderlaminiert und elektrisch durchkontaktiert werden. Diese Leiterplatte kann z.B. auch als vorgeformtes Flexboard den gesamten Aktor umhüllen und schützen. Statt die Außenelektroden auf den Aktor zu löten, können auch leitfähige Kleber verwendet werden. Die zu verwendenden Werkstoffe sind im wesentlichen von den gewünschten Einsatzbedingungen abhängig. Für hohe Temperaturen und rasche Temperaturwechsel eignen sich insbesondere PTFE- und Polyimid-Werkstoffe und Ausdehnungslegierungen wie FeNi₄₂.

## Patentansprüche

1. Außenelektrode an einem piezokeramischen Vielschichtaktor, **dadurch gekennzeichnet, dass** die Außenelektrode (23, 24; 26, 27) aus abwechselnd übereinander angeordneten Schichten leitender Werkstoffe (19) und nicht leitender Werkstoffe (22, 25) besteht, dass von den beiden außen liegenden Schichten aus leitenden Werkstoffen (19) die eine mit der Grundmetallisierung (11) des Aktors (1) verbunden ist und die andere mit der Zuleitung (6, 28) für die Spannung und dass die Schichten aus den leitenden Werkstoffen (19) leitend miteinander verbunden sind.

2. Außenelektrode nach Anspruch 1, **dadurch gekennzeichnet, dass** sie aus mindestens zwei Lagen eines leitenden Werkstoffs (19) und einer dazwischen angeordneten Lage eines nicht leitenden Werkstoffs (22, 25) besteht.

3. Außenelektrode nach Anspruch 1 oder 2, **dadurch gekennzeichnet, dass** die Schichten leitender Werkstoffe (19) jeweils aus einer Folie aus Metall bestehen.

4. Außenelektrode nach Anspruch 3, **dadurch gekennzeichnet, dass** die Folie (19) eine Dicke von etwa 30 µm bis zu etwa 200 µm, vorzugsweise zwischen 50 µm und 100 µm, hat.

5. Außenelektrode nach Anspruch 3 oder 4, **dadurch gekennzeichnet, dass** die Folie (19) eine räumliche Strukturierung aufweist und dass **dadurch** die Schicht eine Gesamtdicke bis zur dreifachen Dicke der Folie erreichen kann.

6. Außenelektrode nach Anspruch 1 oder 2, **dadurch gekennzeichnet, dass** die Schichten leitender Werkstoffe (19) in sich dreidimensional strukturiert sind.

7. Außenelektrode nach Anspruch 6, **dadurch gekennzeichnet, dass** die Schichten leitender Werkstoffe (19) aus Metallgewebe oder -gewirk, aus einem Netz oder aus Metallschaum bestehen.

8. Außenelektrode nach Anspruch 7, **dadurch gekennzeichnet, dass** die Gewebe, Gewirke oder Netze der Schichten leitender Werkstoffe (19) eine Dicke von etwa 100 µm bis zu 200 µm haben.

9. Außenelektrode nach Anspruch 7 oder 8, **dadurch gekennzeichnet, dass** die Maschenweite der Gewirke oder Netze der Schichten leitender Werkstoffe (19) zwischen etwa 100 µm und 200 µm liegen und die Drahtdurchmesser zwischen etwa 50 µm und 100 µm.

10. Außenelektrode nach einem der Ansprüche 1 bis 9, **dadurch gekennzeichnet, dass** der nicht leitende Werkstoff (22, 25) ein elastischer Kunststoff ist, vorzugsweise ein thermoplastischer Kunststoff wie Polytetrafluorethylen (PTFE) oder Polyimid.

11. Außenelektrode nach Anspruch 10, **dadurch gekennzeichnet, dass** der nicht leitende Werkstoff (22, 25) ein Kunststoff in Form von Folien ist mit einer Dicke von etwa 10 µm bis zu etwa 100 µm.

12. Außenelektrode nach einem der Ansprüche 1 bis 11, **dadurch gekennzeichnet, dass** der leitende Werkstoff (19) mit dem nicht leitenden Werkstoff (22, 25) beschichtet ist.

13. Außenelektrode nach einem der Ansprüche 1 bis 12, **dadurch gekennzeichnet, dass** die einzelnen Schichten der leitenden Werkstoffe (19) aus unterschiedlichen metallischen Werkstoffen bestehen.

14. Außenelektrode nach einem der Ansprüche 1 bis 13, **dadurch gekennzeichnet, dass** der leitende Werkstoff (19) mindestens der Schicht, die auf den Aktorwerkstoff gelötet ist, einen dem keramischen Werkstoff des Aktors (1) angepassten Wärmeausdehnungskoeffizienten besitzt.

15. Außenelektrode nach einem der Ansprüche 1 bis 14, **dadurch gekennzeichnet, dass** sie durch Zusammenlaminieren der Schichten aus den leitenden Werkstoffen (19) und den nicht leitenden Werkstoffen (22, 25) hergestellt ist.

16. Außenelektrode nach einem der Ansprüche 1 bis 15, **dadurch gekennzeichnet, dass** die leitende Verbindung zwischen den Schichten aus den leitenden Werkstoffen (19) mittels Durchkontaktieren oder Umkontaktieren hergestellt ist.

17. Außenelektrode nach Anspruch 16, **dadurch gekennzeichnet, dass** die Schichten aus den leitenden Werkstoffen (19) jeweils an ihren Längsseiten miteinander verbunden sind.

18. Außenelektrode nach einem der Ansprüche 1 bis 14, **dadurch gekennzeichnet, dass** der leitende Werkstoff (19) mäanderförmig oder spiralförmig gefaltet ist und dass der nicht leitende Werkstoff (22, 25) jeweils zwischen zwei übereinanderliegenden Lagen des leitenden Werkstoffs (19) angeordnet ist.

19. Außenelektrode nach einem der Ansprüche 1 bis 14, **dadurch gekennzeichnet, dass** der leitende Werkstoff (19) C-förmig gebogen ist, dass er die Lage des nicht leitenden Werkstoffs (22) umschließt und dass die umgebogenen Seiten mit der Grundmetallisierung (11) des Aktors (1) verbunden sind.

20. Außenelektrode nach einem der Ansprüche 1 bis 19, **dadurch gekennzeichnet, dass** der leitende Werkstoff (19) aus einer Kupfer- oder Silber-Legierung besteht.

21. Außenelektrode nach einem der Ansprüche 1 bis 19, **dadurch gekennzeichnet, dass** der leitende Werkstoff (19) aus einer Eisen-Nickel-Legierung oder einer Eisen-Nickel-Cobalt-Legierung besteht.

22. Außenelektrode nach einem der Ansprüche 1 bis 21, **dadurch gekennzeichnet, dass** sie durch Anlöten oder durch Ankleben mit einem leitfähigen Klebstoff mit der Grundmetallisierung (11) des Aktors (1) verbunden ist.

## Claims

1. External electrode for a multilayer piezoceramic actuator, **characterised in that** the external electrode (23, 24; 26; 27) consists of conductive material layers (19) and nonconductive material layers (22, 25) arranged alternately above one another, **in that** one of the two outlying conductive material layers (19) is connected to the base metallization (11) of the actuator (1) and the other is connected to the voltage supply lead (6, 28), and **in that** the conductive material layers (19) are electrically connected to one another.

2. External electrode according to Claim 1, **characterised in that** it consists of at least two layers of a conductive material (19) and a layer of a nonconductive material (22, 25) arranged between them.

3. External electrode according to Claim 1 or 2, **characterised in that** each conductive material layer (19) consists of a metal foil.

4. External electrode according to Claim 3, **characterised in that** the foil (19) has a thickness of about 30 µm to about 200 µm, preferably between 50 µm and 100 µm.

5. External electrode according to Claim 3 or 4, **characterised in that** the foil (19) has a spatial structure, and **in that** the layer can therefore attain an overall thickness up to three times the thickness of the foil.

6. External electrode according to Claim 1 or 2, **characterised in that** the conductive material layers (19) are three-dimensionally structured.

7. External electrode according to Claim 6, **characterised in that** the conductive material layers (19) consist of metal gauze or fabric, of a mesh or of metal foam.

8. External electrode according to Claim 7, **characterised in that** the gauzes, fabrics or meshes of the conductive material layers (19) have a thickness of about 100 µm to 200 µm.

9. External electrode according to Claim 7 or 8, **characterised in that** the lattice widths of the fabrics or meshes of the conductive material layers (19) are between about 100 µm and 200 µm, and the wire diameters are between about 50 µm and 100 µm.

10. External electrode according to one of Claims 1 to 9, **characterised in that** the nonconductive material (22, 25) is a resilient plastic, preferably a thermoplastic such as polytetrafluoroethylene (PTFE) or polyimide.

11. External electrode according to Claim 10, **characterised in that** the nonconductive material (22, 25) is a plastic, in the form of films with a thickness of about 10 µm to about 100 µm.

12. External electrode according to one of Claims 1 to 11, **characterised in that** the conductive material (19) is coated with the nonconductive material (22, 25).

13. External electrode according to one of Claims 1 to 12, **characterised in that** the individual conductive material layers (19) consist of different metallic materials.

14. External electrode according to one of Claims 1 to 13, **characterised in that** the conductive material (19), at least of the layer which is soldered to the actuator material, has a coefficient of thermal expansion matched to the ceramic material of the actuator (1).

15. External electrode according to one of Claims 1 to 14, **characterised in that** it is produced by colaminating the conductive material layers (19) and the nonconductive material layers (22, 25).

16. External electrode according to one of Claims 1 to 15, **characterised in that** the electrical connection between the conductive material layers (19) is established by via-contacts or contacts leading around.

17. External electrode according to Claim 16, **characterised in that** the conductive material layers (19) are respectively connected to one another on their long sides.

18. External electrode according to one of Claims 1 to 14, **characterised in that** the conductive material (19) is folded into a meandering or spiral shape, and **in that** the nonconductive material (22, 25) is respectively arranged between two superimposed layers of the conductive material (19).

19. External electrode according to one of Claims 1 to 14, **characterised in that** the conductive material (19) is bent into a C-shape, **in that** it encloses the nonconductive material layer (22), and **in that** the bent sides are connected to the base metallization (11) of the actuator (1).

20. External electrode according to one of Claims 1 to 19, **characterised in that** the conductive material (19) consists of a copper or silver alloy.

21. External electrode according to one of Claims 1 to 19, **characterised in that** the conductive material (19) consists of an iron-nickel alloy or an iron-nickel-cobalt alloy.

22. External electrode according to one of Claims 1 to 21, **characterised in that** it is connected to the base metallization (11) of the actuator (1) by soldering or by bonding with a conductive adhesive.

## Revendications

1. Electrode externe disposée sur un actionneur piézocéramique multicouche, **caractérisée en ce que** l'électrode externe (23, 24 ; 25, 26) est constituée de couches superposées qui sont composées alternativement de matières conductrices (19) et de matières non conductrices (22, 25), et des deux couches externes en matières conductrices (19), l'une est reliée à la métallisation de base (11) de l'actionneur tandis que l'autre est reliée à un conducteur (28) de tension, les couches en matières conductrices (19) étant reliées entre elles.

2. Electrode externe selon la revendication 1, **caractérisée en ce qu'**elle est constituée d'au moins deux couches d'une matière conductrice (19) et d'une couche d'une matière non conductrice (22, 25) disposée entre les précédentes.

3. Electrode selon la revendication 1 ou 2, **caractérisée en ce que** les couches en matières conductrices (19) sont constituées chacune par une feuille en métal.

4. Electrode externe selon la revendication 3, **caractérisée en ce que** la feuille (19) a une épaisseur comprise entre 30 et 200 microns environ, de préférence entre 50 et 100 microns.

5. Electrode externe selon la revendication 3 ou 4, **caractérisée en ce que** la feuille (19) présente une structure spatiale de sorte que l'épaisseur totale de la couche peut être jusqu'à trois fois celle de la feuille.

6. Electrode externe selon la revendication 1 ou 2, **caractérisée en ce que** les couches de matières conductrices (19) sont structurées dans les trois dimensions.

7. Electrode externe selon la revendication 1, **caractérisée en ce que** les couches de matières conductrices (19) sont constituées d'un tissu ou tricot métallique, d'un réseau ou d'une mousse métallique.

8. Electrode externe selon la revendication 7, **caractérisée en ce que** les tissus, les tricots ou les réseaux des couches conductrices (19) ont une épaisseur de 100 à 200 microns environ.

9. Electrode externe selon la revendication 7 ou 8, **caractérisée en ce que** la dimension des mailles des tissus u des réseaux des couches de matières conductrices (19) est comprise entre 100 et 200 microns et le diamètre du fil est compris entre 50 et 100 microns.

10. Electrode externe selon une des revendications 1 à 9, **caractérisée en ce que** la matière non conductrice (22, 25) est une matière plastique élastique, de préférence une matière thermoplastique telle que du polytétrafluorethylène (PTFE) ou une polyimide.

11. Electrode externe selon la revendication 10, **caractérisée en ce que** la matière non conductrice (22, 25) est une matière plastique sous la forme de feuilles dont l'épaisseur est de 10 à 100 microns.

12. Electrode externe selon une des revendications 1 à 11, **caractérisée en ce que** la matière conductrice (19) est garnie d'une couche non conductrice (22, 25).

13. Electrode externe selon une des revendications 1 à 12, **caractérisée en ce que** les couches individuelles de matières conductrices (19) sont constituées de matières métalliques différentes.

14. Electrode externe selon une des revendications 1 à 13, **caractérisée en ce que** la matière conductrice (19) composant au moins la couche qui est brasée sur la matière de l'actionneur, possède un coefficient de dilatation thermique adapté à la matière céramique de l'actionneur (1).

15. Electrode externe selon une des revendications 1 à 14, **caractérisée en ce qu'**elle est fabriquée en laminant ensemble les couches de matières conductrices (19) et les couches de matières non conductrices (22, 25)..

16. Electrode externe selon une des revendications 1 à 15, **caractérisée en ce que** la liaison conductrice entre les couches en matières conductrices (19) est assurée par des contacts traversants ou enveloppants.

17. Electrode externe selon la revendication 16, **caractérisée en ce que** les couches en matières conductrices (19) sont reliées entre elles par les côtés longitudinaux.

18. Electrode externe selon une des revendications 1 à 14, **caractérisée en ce que** la matière conductrice (19) est pliée en forme de méandres ou de spirales et la matière non conductrice (22, 25) est disposée chaque fois entre deux couches superposées de la matière conductrice (19).

19. Electrode externe selon une des revendications 1 à 14, **caractérisée en ce que** la matière conductrice (19) est recourbée en forme de C qui entoure la couche de matière non conductrice (22), et les côtés recourbés sont reliés à la métallisation de base (11) de l'actionneur (1).

20. Electrode externe selon une des revendications 1 à 19, **caractérisée en ce que** la matière conductrice (19) est un alliage de cuivre ou d'argent.

21. Electrode externe selon une des revendications 1 à 19, **caractérisée en ce que** la matière conductrice (19) est un alliage de fer-nickel ou un alliage de fer-nickel-cobalt.

22. Electrode externe selon une des revendications 1 à 21, **caractérisée en ce qu'**elle est reliée à la métallisation de base (11) de l'actionneur (1) par brasage ou collage par un adhésif conducteur.
